**Europäisches Patentamt**

**European Patent Office**

**Office européen des brevets**

(19)

(11) Veröffentlichungsnummer : **0 682 261 A2**

## (12) EUROPÄISCHE PATENTANMELDUNG

(21) Anmeldenummer : **95810269.1**

(22) Anmeldetag : **24.04.95**

(51) Int. Cl.⁶ : $G01R\ 15/24$

(30) Priorität : **09.05.94 DE 4416298**

(43) Veröffentlichungstag der Anmeldung :
**15.11.95 Patentblatt 95/46**

(84) Benannte Vertragsstaaten :
**DE FR GB**

(71) Anmelder : **ABB RESEARCH LTD.**
**Affolternstrasse 52**
**CH-8050 Zürich 11 (CH)**

(72) Erfinder : **Bohnert, Klaus, Dr.**
**Loonstrasse 9**
**CH-5443 Niederrohrdorf (CH)**
Erfinder : **Nehring, Jürgen, Dr.**
**Neustrasse 47**
**CH-5430 Wettingen (CH)**

(74) Vertreter : **Rzehak, Herbert et al**
**c/o ABB Management AG,**
**Abt. TEI-Immaterialgüterrecht**
**CH-5401 Baden (CH)**

(54) **Verfahren und Vorrichtung zur optischen Ermittlung einer physikalischen Grösse.**

(57)    Zum Detektieren insbesondere einer elektrischen Hochspannung (8) wird ein elektrooptischer Sensor mit einem elektrooptischen Kristall (4) verwendet, wie er in Pockelszellen zur Anwendung kommt. Von einer Lichtquelle (L) wird Licht über einen Faserkoppler (FK), ein Glasfaserkabel (F1), einen Kollimator (K1), einen 1. Polarisator (P1), einen Strahlteiler (1), 1. und 2. Glasplatten (2, 3) in den elektrooptischen Kristall (4) linearpolarisiert eingestrahlt. An dessen Endfläche befindet sich eine 3. Glasplatte (5) mit einer Schichtelektrode (6), die gleichzeitig als Spiegel (7) wirkt und das einfallende Licht durch den elektrooptischen Kristall (4) zurückreflektiert. Ein Teilstrahl (T1) des reflektierten Lichtes gelangt über den Strahlteiler (1) und den nun als Analysator wirkenden 1. Polarisator (P1) zurück zu einem 1. Lichtdetektor (D1). Ein 2. Teilstrahl (T2) gelangt über eine λ/4-Verzögerungsplatte (9), einen 2. Polarisator (P2), ein 90°-Prisma (10), einen Kollimator (K2) und ein 2. Glasfaserkabel (F2) zu einem 2. Lichtdetektor (D2). Eine Auswertung von Lichtintensitäten ($I_1$) und ($I_2$) erfolgt mittels eines Mikroprozessors (14). Dadurch, daß die beiden phasenverschobenen Lichtsignale aus einem gemeinsamen optischen Kanal abgeleitet werden, hat eine intrinsische Doppelbrechung des elektrooptischen Kristalls (4) keinen Einfluß auf deren Phasenunterschied. Anstelle eines Spiegels (7) kann ein 90°-Prisma zur Lichtumkehr verwendet werden. Ein- und Ausgangskanäle des Lichtes können getrennt sein. Es werden Wege zur Temperaturkompensation eines Meßergebnissignals (S) angegeben.

FIG.1a

EP 0 682 261 A2

TECHNISCHES GEBIET

Bei der Erfindung wird ausgegangen von einem Verfahren und einer Vorrichtung zur optischen Ermittlung einer physikalischen Größe nach dem Oberbegriff der Patentansprüche 1 und 6.

STAND DER TECHNIK

Mit den Oberbegriffen der Patentansprüche 1 und 6 nimmt die Erfindung auf einen Stand der Technik Bezug, wie er aus der US-A-4,904,931 bekannt ist. Dort werden 2 zueinander parallele Lichtstrahlen durch einen 1. Polarisator, danach durch einen elektrooptischen Kristall, durch je eine $\lambda$/8-Platte bzw. 45°-Verzögerungsplatte mit + 45° bzw. - 45° Phasenverschiebung und danach durch einen beiden Lichtstrahlen gemeinsamen 2. Polarisator geschickt. Die Ausgangssignale werden mittels Photodioden getrennt erfaßt, in elektrische Signale umgewandelt und ausgewertet. Als elektrooptischer Kristall wird ein Kristall aus Kaliumhydrogenphosphat verwendet, wie er in Pockelszellen zur Anwendung kommt. Parallel zur Richtung der Lichtausbreitung weist dieser Kristall eine 4fache Drehsymmetrie auf; in einer Ebene senkrecht zur dieser Hauptrichtung weist er 2 elektrooptische Hauptachsen auf, die orthogonal zueinander orientiert sind und längs denen sich Licht unterschiedlich schnell ausbreitet, wenn an dem Kristall eine elektrische Spannung parallel zur Richtung der Lichtausbreitung anliegt. Die Differenz der unterschiedlichen Ausbreitungsgeschwindigkeiten ist proportional zur elektrischen Spannung, so daß aus dem Laufzeitunterschied die elektrische Spannung bestimmt werden kann. Die beiden als Lichtquellen verwendeten lichtemittierenden Photodioden werden in Abhängigkeit von den beiden um 90° phasenverschobenen Ausgangssignalen der Empfangsdioden auf einen konstanten und gleichen Spitzenwert geregelt. Bei großen Spannungen kann die spannungsbedingte Phasenverschiebung des Lichtes in dem elektrooptischen Kristall mehrere Perioden durchlaufen, so daß bei der Auswertung der gemessenen Lichtintensität I nur eines Lichtstrahles der Zusammenhang zwischen dem Ausgangssignal und der zu messenden Spannung mehrdeutig wäre. Für I gilt:

$$I = I_0 \cdot (1 + \sin \Gamma)/2, \quad (1)$$

wobei $I_0$, abgesehen von Verlusten im Kristall, in den Polarisatoren usw., die am 1. Polarisator eintreffende Lichtintensität und $\Gamma$ die durch die induzierte Doppelbrechung erzeugte optische Phasenverschiebung, welche proportional zum angelegten elektrischen Feld ist, bedeuten. Für eine sinusförmige Wechselspannung ist $\Gamma(t)$ = $\Gamma_0 \cdot \sin (\omega \cdot t)$ mit $\omega$ = Kreisfrequenz und t = Zeit. U. a. ist es ohne weitere Maßnahmen nicht möglich, die Richtung der Spannung, zunehmend oder abnehmend, eindeutig zu bestimmen, wenn die Scheitelpunkte der Spannung zeitlich mit einem Extremwert der Funktion sin $\Gamma(t)$ zusammenfallen. In der US-A-4,904,931 wird dieses Problem dadurch gelöst, daß der Sensor mit einem 2. optischen Kanal ausgestattet wird. Mit Hilfe 2er 45°-Verzögerungsplatten wird zwischen den beiden Kanälen ein Phasenunterschied von 90° eingestellt.

$$\text{Kanal 1: } I_1(t) = I_0 \cdot (1 + \sin (\Gamma(t) - 45°))/2,$$
$$\text{Kanal 2: } I_2(t) = I_0 \cdot (1 + \sin (\Gamma(t) + 45°))/2. \quad (2)$$

Diese um 90° phasenverschobenen Signale können mit einer entsprechenden Auswertelektronik so verarbeitet werden, daß als Ausgangssignal wieder ein zeitliches Abbild der am Kristall anliegenden Wechselspannung entsteht.

Der zusätzliche 2. Kanal führt dazu, daß sich die Anzahl der meisten optischen Komponenten: Lichtquelle, Glasfaserkabel, Kollimatoren, Polarisatoren, verdoppelt, was die Sensorkosten deutlich erhöht. Die oft nicht vernachlässigbare Doppelbrechung des Kristalls infolge eingefrorener mechanischer Spannungen und Defekte ist gewöhnlich für beide Kanäle verschieden. Als Folge davon weicht der tatsächliche Phasenunterschied zwischen beiden Kanälen von 90° ab und ist darüberhinaus temperaturabhängig. Die Optik für die beiden Kanäle hat einen vergleichsweise großen Platzbedarf und macht einen entsprechend großen Kristallquerschnitt erforderlich. Ein großer Kristallquerschnitt wirkt sich aber ungünstig auf die elektrische Durchschlagfestigkeit der Gesamtanordnung aus und vergrößert die Kristallkosten.

DARSTELLUNG DER ERFINDUNG

Die Erfindung, wie sie in den Patentansprüchen 1 und 6 definiert ist, löst die Aufgabe, ein Verfahren und eine Vorrichtung zur optischen Ermittlung einer physikalischen Größe der eingangs genannten Art derart weiterzuentwickeln, daß die beiden phasenverschobenen Signale zur Bildung der physikalischen Größe aus einem gemeinsamen optischen Kanal abgeleitet werden können.

Vorteilhafte Ausgestaltungen der Erfindung sind in den abhängigen Patentansprüchen definiert.

Ein Vorteil der Erfindung besteht darin, daß die intrinsische Doppelbrechung des Kristalls keinen Einfluß mehr auf den Phasenunterschied zwischen den beiden Signalen hat. Ferner sind weniger optische Komponenten erforderlich. Es wird nur noch eine optische Lichtquelle benötigt. Der Kristallquerschnitt kann wegen des kleineren Platzbedarfs wesentlich reduziert werden.

KURZE BESCHREIBUNG DER ZEICHNUNGEN

Die Erfindung wird nachstehend anhand von Ausführungsbeispielen erläutert. Es zeigen:

| | |
|---|---|
| Fig. 1a und 1b | Sensorkonfigurationen mit vereinigtem Sende- und Empfangspfad, |
| Fig. 2a und 2b | Winkelorientierungen von Komponenten der Sensorkonfigurationen gemäß den Fig. 1a bzw. 1b, |
| Fig. 3 | Fehlerkurven einer 90°-Phasenverschiebung als Funktion der relativen Phasenverzögerung zwischen einer s- und p-Polarisation an einem Strahlteiler der Sensorkonfigurationen gemäß den Fig. 1a und 1b, |
| Fig. 4 | den Kontrast der elektrooptischen Modulation im Kanal mit einer $\lambda/4$-Platte als Funktion der relativen Phasenverzögerung zwischen einer s- und p-Polarisation an einem Strahlteiler, |
| Fig. 5 | relative Lichtleistungen für die Sendekonfigurationen gemäß den Fig. 1a und 1b, |
| Fig. 6a und 6b | Sensorkonfigurationen mit getrennten Sende- und Empfangspfaden, |
| Fig. 7 | einen Lichtpfad in einem elektrooptischen Kristall bei Verwendung eines Spiegels anstelle eines Prismas bei den Sensorkonfigurationen gemäß den Fig. 6a und 6b, |
| Fig. 8 | relative Lichtleistungen für die Sensorkonfigurationen gemäß den Fig. 6a und 6b für ein Teilerverhältnis eines Strahlteilers von 1 : 1, |
| Fig. 9 | ein Signaldiagramm 2er elektrooptischer Signale als Funktion der Zeit zur Erläuterung der Temperaturkompensation und |
| Fig. 10 und 11 | Sensoren für eine dynamische optische Druck-bzw. Kraftmessung. |

WEGE ZUR AUSFÜHRUNG DER ERFINDUNG

In den Figuren sind gleiche Teile mit gleichen Bezugszeichen gekennzeichnet.

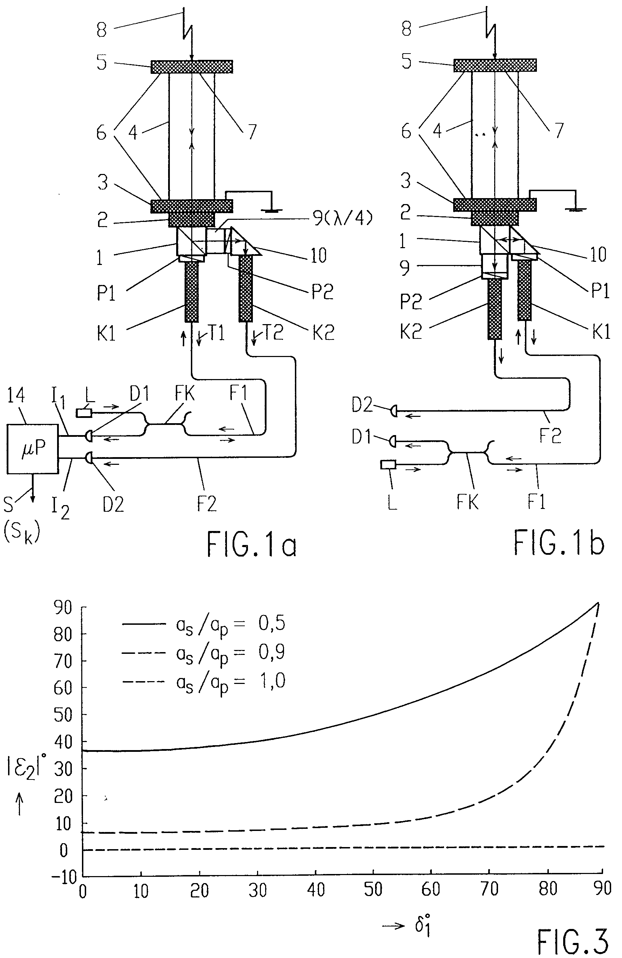

Die Fig. 1a und 1b zeigen 2 Varianten eines Sensoraufbaus mit vereinigten Sende- und Empfangspfaden. Bei dem Sensoraufbau gemäß Fig. 1a durchläuft das von einer Lichtquelle (L), z. B. einer Laserdiode, emittierte Licht zunächst einen faseroptischen Strahlteiler bzw. Faserkoppler (FK) und dann ein Faserkabel, vorzugsweise ein Glasfaserkabel (F1), durch welches es zum Sensorkopf übertragen wird. Dort wird das Licht durch einen 1. Kollimator (K1) kollimiert und danach durch einen nachgeschalteten 1. Polarisator (P1) linear polarisiert. Es durchläuft dann nacheinander einen Strahlteiler (1), 1. und 2. Glasplatten (2, 3) und einen elektrooptischen Kristall (4), der endseitig von einer elektrisch leitenden, lichtreflektierenden, verspiegelten 3. Glasplatte (5) abgeschlossen ist. Mit (6) sind Schichtelektroden bezeichnet, wobei die Schichtelektrode auf der 2. Glasplatte (3) eine elektrisch geerdete durchsichtige Indiumzinnoxidschicht ist. Mit (7) ist ein Spiegel bezeichnet. Bei der 3. Glasplatte (5) dient die Schichtelektrode (6) gleichzeitig als Spiegel (7); sie besteht aus einer vergoldeten Chromschicht, welche die 3. Glasplatte (5) umgibt. An der 3. Glasplatte (5) wird der Lichtstrahl in sich zurückreflektiert, so daß er den elektrooptischen Kristall (4) noch einmal durchläuft. Im Strahlteiler (1) wird er in 2 Teilstrahlen (T1, T2) zerlegt. Ein 1. transmittierter Teilstrahl (T1) läuft über den 1. Polarisator (P1), der jetzt als Analysator wirkt, durch den 1. Kollimator (K1) und das Glasfaserkabel (F1) zu dem Faserkoppler (FK). Von dort gelangt ein durch das Köppelverhältnis bestimmter Anteil des Lichtes zu einem optoelektrischen Detektor bzw. zu einem 1. Lichtdetektor (D1), welcher ausgangsseitig ein der empfangenen Lichtintensität proportionales elektrisches Signal ($I_1$) an eine Auswertelektronik oder einen Rechner bzw. Mikroprozessor (14) liefert, an dem ausgangsseitig ein Meßergebnissignal (S) abgreifbar ist.

Ein am Strahlteiler (1) reflektierter 2. Teilstrahl (T2) durchläuft zunächst eine Phasenverzögerungsplatte, vorzugsweise eine $\lambda/4$-Verzögerungsplatte (9), danach einen 2. Polarisator (P2), ein Umlenkprisma bzw. 90°-Prisma (10) und einen 2. Kollimator (K2), welcher den Teilstrahl (T2) in ein 2. Glasfaserkabel (F2) einkoppelt. Durch dieses Glasfaserkabel (F2) gelangt der Teilstrahl (T2) schließlich zu einem 2. Lichtdetektor (D2), welcher ausgangsseitig ein der empfangenen Lichtintensität proportionales elektrisches Signal ($I_2$) an den Mikroprozessor (14) liefert.

Die 3 Glasplatten (2, 3, 5) sind für die prinzipielle Funktionsweise des Sensors unwesentlich. In der Praxis dienen sie als Halterungselemente und Substrate für die aufgedampften Schichtelektroden (6), an welche eine zu detektierende elektrische Spannung bzw. Hochspannung (8) angelegt wird. Die 1. Glasplatte (2) dient lediglich als Zwischenelement. Um thermisch induzierte Spannungen möglichst klein zu halten, sollte das Glas der 3 Glasplatten (2, 3, 5) einen ähnlichen thermischen Ausdehnungskoeffizienten wie der elektrooptische Kristall (4) haben.

In Fig. 1b sind im Unterschied zu Fig. 1a Ein- und Ausgangskanäle miteinander vertauscht.

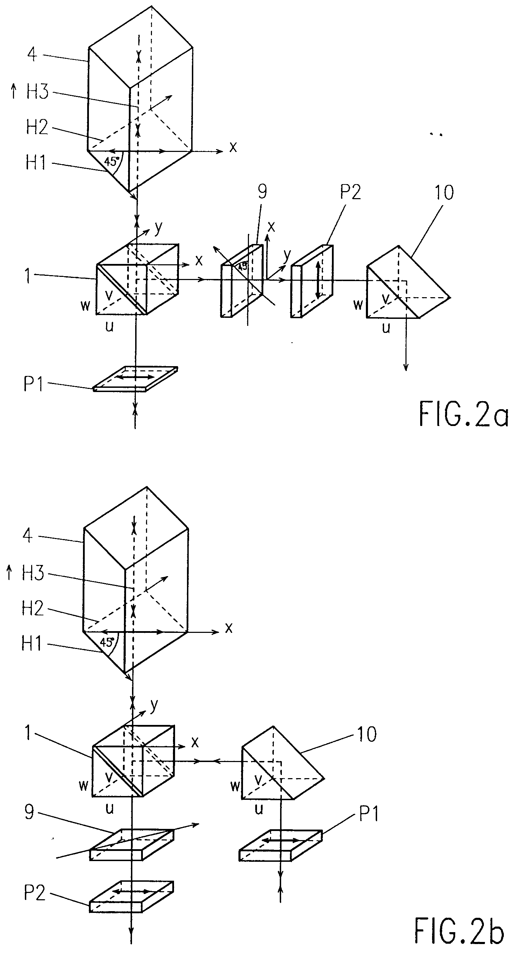

Fig. 2a gibt die Winkelorientierung der optischen Komponenten für die Sensorkonfiguration gemäß Fig. 1a an. Die Polarisationsrichtung des 1. Polarisators (P1) ist parallel zu einer der beiden zueinander orthogonalen Kanten (u, v) der Grundfläche des Strahlteilers (1), dessen 3. Kante (w) zu den anderen beiden Kanten orthogonal ist. Die Polarisation ist also parallel oder senkrecht zu der bei der Strahlteilung relevanten optischen Einfallsebene (p- bzw. s-Polarisation in Polarisationsrichtungen (x) bzw. (y), d. h. Polarisationen parallel und senkrecht zur jeweiligen optischen Einfallsebene). Diese lineare Polarisation bleibt dann bei der Transmission durch den Strahlteiler (1) erhalten. Eine andere Orientierung des 1. Polarisators (P1) hätte zur Folge, daß das Licht in einen elliptischen Polarisationszustand übergehen würde, da s- und p-Anteile bei der Transmission durch den Strahlteiler (1) im allgemeinen unterschiedliche phasenverschiebungen erfahren. 2 elektrooptisch ausgezeichnete 1. und 2. Achsen (H1, H2) des elektrooptischen Kristalls (4) stehen senkrecht zur Strahlrichtung und auch senkrecht zu einer 3. ausgezeichneten optischen Achse (H3) des elektrooptischen Kristalls (4) in Strahlrichtung. Die 1. und 2. elektrooptisch ausgezeichneten Achsen (H1, H2) bilden mit der Polarisationsrichtung des einfallenden Lichtes einen 45°-Winkel. Die Endflächen des elektrooptischen Kristalls (4) stehen ebenfalls senkrecht zur Strahlrichtung. Die Hauptachse der $\lambda/4$-Verzögerungsplatte (9) steht senkrecht zur Richtung des am Strahlteiler (1) reflektierten Lichtstrahls und bildet mit den Richtungen der Kanten (v, w) des Strahlteilers (1) einen Winkel von + 45° oder - 45°; sie ist damit gleichzeitig parallel zur Projektion einer der elektrooptischen Achsen des elektrooptischen Kristalls (4). Die Polarisationsrichtung des 2. Polarisators (P2) steht unter 45° zur Hauptachse der $\lambda/4$-Verzögerungsplatte (9). Die Kanten (u, v, w) des 90°-Prismas (10) sind parallel zu den entsprechenden Kanten (u, v, w) des Strahlteilers (1).

Fig. 2b zeigt die Orientierung der Lichtkomponenten für den Sensoraufbau gemäß Fig. 1b.

Amplituden- und Phaseneffekte:

Nachfolgend werden Effekte betrachtet, die sich störend auf die relative Phase $\Gamma$ und einen Modulationskontrast $K_1$ bzw. $K_2$ der elektrooptischen Signale $I_1$, $I_2$ auswirken. Die Schlußfolgerungen, die sich daraus für die Auswahl, Anordnung und Winkelorientierung der Komponenten ergeben, werden erläutert.

Die wichtigsten Störeffekte sind:
- Der Strahlteiler (1) führt für p- und s-Polarisationen sowohl in Reflexion als auch in Transmission unterschiedliche Phasenverschiebungen ein.
- Reflexionsvermögen und Transmission sind für s- und p-Polarisationen im allgemeinen unterschiedlich.
- Das 90°-Prisma (10) führt zwischen s- und p-Polarisationen ebenfalls einen Phasenunterschied ein.

Hinzu können noch Störeffekte auf Grund einer ungenauen $\lambda/4$-Verzögerungsplatte (9) und/oder einer ungenauen Winkeljustierung der Komponenten kommen.

Die Signale $I_1$ und $I_2$ in den beiden Kanälen können dargestellt werden als:

$$I_1(t) = I_0 \cdot [A_1 + B_1 \cdot \cos (\Gamma - \epsilon_1)]/2 \text{ und} \quad (3)$$
$$I_2(t) = I_0 \cdot [A_2 + B_2 \cdot \cos (\Gamma + \pi/2 - \epsilon_2)]/2, \quad (4)$$

wobei Gleichung (3) für den Kanal ohne und Gleichung (4) für den Kanal mit $\lambda/4$-Verzögerungsplatte (9) gilt. Dabei bezeichnen $A_1$, $B_1$ bzw. $A_2$, $B_2$ Koeffizienten zur Bestimmung des Modulationskontrastes $K_1$ bzw. $K_2$ mit $K_1 = B_1/A_1$ und $K_2 = B_2/A_2$, $\Gamma$ die elektrooptische Phasenverschiebung, $\epsilon_1$ und $\epsilon_2$ zusätzliche Phasenterme, die zu einer Abweichung von der 90°-Phasenverschiebung führen.

Im Idealfall gilt: $A_1 = B_1 = A_2 = B_2 = 1$ und $\epsilon_1 = \epsilon_2 = 0$.

1. Einfluß des Strahlteilers:

Im Kanal ohne $\lambda/4$-Verzögerungsplatte (9) haben die o. g. Störeffekte auf den Kontrast und die 90°-Phasenverschiebung keinen Einfluß, wenn die in den Fig. 2a und 2b gezeigten Orientierungen gewählt werden, d. h., es gilt dann $A_1 = B_1 = 1$ und $\epsilon_1 = 0$ und folglich: $I_1 = I_0 \cdot [1 + \cos \Gamma]/2$.

Für den Kanal mit $\lambda/4$-Verzögerungaplatte (9) und den Spezialfall $\delta_1 \neq 0$, $a_s = a_p$ gilt:
$A_2 = 1$, $B_2 = \cos \delta_1$, $\epsilon_2 = 0$ und damit

$$I_2 = I_0 \cdot [1 + \cos \delta_1 \cdot \cos (\Gamma + \pi/2]/2, \quad (5)$$

wobei $a_s$ und $a_p$ die Lichtstärkeamplituden für s- und p-Polarisation nach der Reflexion am Strahlteiler (1) bzw. nach der 2. Transmission durch den Strahlteiler (1) und $\delta_1$ die durch den Strahlteiler (1) eingeführte Phasenverschiebung zwischen s- und p-Polarisation bedeuten, die üblicherweise für Reflexion und Transmission unterschiedlich ist.

Der Modulationskontrast $K_2$ wird um einen Faktor $\cos \delta_1$ herabgesetzt. Die 90°-Phasenverschiebung bleibt unbeeinflußt ($\epsilon_2 = 0$).

Für den Kanal mit $\lambda/4$-Verzögerungsplatte (9) und den allgemeinen Fall $\delta_1 \neq 0$, $a_s \neq a_p$ erhält man:

$$A_2 = (a_s^2 + a_p^2)/2, \quad (6)$$
$$B_2 = [a_s^2 \cdot a_p^2 \cdot \cos^2 \delta_1 + (a_s^2 - a_p^2)^2/4]^{0,5} \text{ und} \quad (7)$$

$$\epsilon_2 = \text{arc tan } (a_s^2 - a_p^2)/(\pm 2 \cdot a_s \cdot a_p \cdot \cos \delta_1). \quad (8)$$

Das $\pm$-Zeichen bezieht sich auf die Orientierung der $\lambda/4$-Verzögerungsplatte (9), d. h. auf die schnelle Achse unter $\pm 45°$ bezüglich der Polarisationsrichtung (x). In diesem Fall wird im Prinzip sowohl der Modulationskontrast $K_2$ als auch die 90°-Phasenverschiebung durch den Strahlteiler (1) beeinflußt.

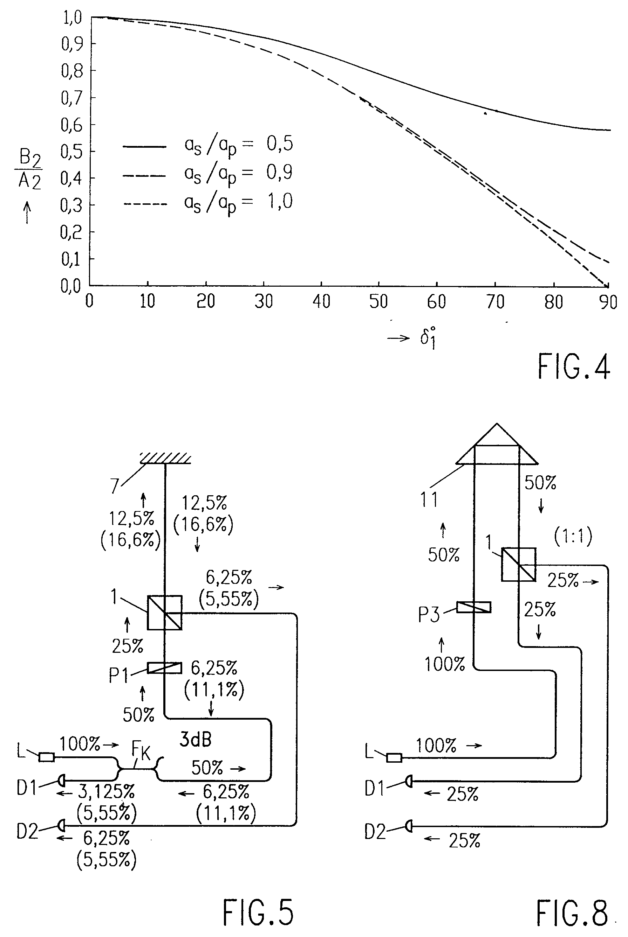

Fig. 3 zeigt den Betrag $|\epsilon_2|$ des Fehlers der 90°-Phasenverschiebung als Funktion der relativen Phasenverzögerung $\delta_1$ des Strahlteilers (1) für Amplitudenverhältnisse $a_s/a_p = 0,5$ bzw. 0,9 bzw. 1,0. Man erkennt, daß die relative Phasenverzögerung $\delta_1$ keinen Einfluß auf die 90°-Phasenverschiebung hat ($\epsilon_2 = 0$), wenn die Amplituden $a_s$, $a_p$ für die s- und p-Polarisation gleich sind (kurz gestrichelte Linie). Für ungleiche Amplituden ist dagegen immer ein Fehler vorhanden, vgl. die langgestrichelte und durchgezogene Linie.

Fig. 4 zeigt den Modulationskontrast $K_2 = B_2/A_2$ als Funktion der relativen Phasenverzögerung $\delta_1$ für die 3 in Verbindung mit Fig. 3 angegebenen Amplitudenverhältnisse $a_s/a_p = 0,5$ bzw. 0,9 bzw. 1,0. Für relative Phasenverzögerungen $\delta_1$ am Strahlteiler (1) von weniger als 10° wird fast unabhängig vom Amplitudenverhältnis $a_s/a_p$ der Modulationskontrast $K_2$ nur unwesentlich beeinträchtigt.

Für einen kommerziell erhältlichen würfelförmigen Strahlteiler (1) mit einer metallisch/dielektrischen Hybrid-Teilerschicht wurden folgende Werte gemessen:

Transmission: $\delta_1 = 1°$, $a_s/a_p = 0,954$,

Reflexion: $\delta_1 = 6°$, $a_s/a_p = 1,049$.

Die Streuung der Werte für verschiedene Exemplare dieses Teilertyps war gering.

Damit wird der Modulationskontrast $K_2$ im Kanal mit $\lambda/4$-Verzögerungsplatte (9) um die Faktoren 0,986 (bei $\lambda/4$-Verzögerungsplatte (9) im Transmissionszweig) bzw. um 0,981 (bei $\lambda/4$-Verzögerungsplatte (9) im Reflexionszweig) reduziert. Die 90°-Phasenverschiebung wird um die Winkel $\epsilon_2 = 2,70°$ bzw. $\epsilon_2 = 2,71°$ gestört. Die Störeffekte sind damit vernachlässigbar klein.

Für Strahlteiler (1) mit einer ausschließlich dielektrischen Teilerschicht ist das Amplitudenverhältnis $a_s/a_p$ extrem stark von 1 verschieden und hat einen dementsprechend großen Einfluß auf den Modulationskontrast $K_2$ und die 90°-Phasenverschiebung, siehe die Fig. 3 und 4.

Vorzugsweise wählt man einen Strahlteilertyp für den das Amplitudenverhältnis $a_s/a_p$ möglichst nahe bei 1 und die Phasenverzögerung $\delta_1$ möglichst nahe bei 0 liegen. Falls die relative Phasenverzögerung $\delta_1$ für Transmission und Reflexion stark unterschiedlich ist, legt man den Kanal mit der $\lambda/4$-Verzögerungsplatte (9) vorzugsweise in den Zweig mit dem kleineren Wert der relativen Phasenverzögerung $\delta_1$.

2. Zusatzeffekt eines Phasenfehlers der $\lambda/4$-Verzögerungsplatte (9):

In der Praxis kann es vorkommen, daß zusätzlich zu den eben erwähnten Störeffekten die Phasenverzögerung durch die $\lambda/4$-Verzögerungsplatte (9) um einen Fehlwinkel $\delta_3$ von der 90°-Phasenverschiebung abweicht. Für die Koeffizienten $A_2$, $B_2$ und den 90°-Fehler $\epsilon_2$ gilt dann für den Fall, daß der 1. Polarisator (P2) (Analysator) parallel zur Polarisationsrichtung (y) ausgerichtet ist (s-Polarisation gemäß den Fig. 2a und 2b):

$$A_2 = (a_s^2 + a_p^2)/2 - (a_s^2 - a_p^2) \cdot \sin \delta_3/2, \quad (9)$$
$$B_2 = \{a_s^2 \cdot a_p^2 \cdot \cos^2 \delta_1 \cdot \cos^2 \delta_3 +$$
$$[(a_s^2 - a_p^2) - (a_s^2 + a_p^2) \cdot \sin \delta_3]^2/4\}^{0,5} \text{ und} \quad (10)$$
$$\epsilon_2 = \text{arc tan } [(a_s^2 - a_p^2) - (a_s^2 + a_p^2) \cdot \sin \delta_3]/$$
$$(\pm 2 \cdot a_s \cdot a_p \cdot \cos \delta_1 \cdot \cos \delta_3). \quad (11)$$

Steht der 1. Polarisator (P2) parallel zur Polarisationsrichtung (x), so ändern sich in Gleichung (4) die Vorzeichen von $B_2$ und $\epsilon_2$, d. h. es ist

$$I_2(t) = I_0 \cdot [A_2 - B_2 \cdot \cos (\Gamma + \pi/2 + \epsilon_2)]/2. \quad (12)$$

In Gleichung (9) ändert sich dementsprechend das 2. Vorzeichen, in Gleichung (10) das 3. und in Gleichung (11) das 2.

Für einen Fehlwinkel $\delta_3 = 1,8°$ erhält man mit $\delta_1 = 1°$ und $a_s/a_p = 0,954$ eine Abweichung von der 90°-Phasenverschiebung um

$\epsilon_2 = 0,90°$ für den 2. Polarisator (P2) $\parallel$ x bzw.

$\epsilon_2 = 4,49°$ für den 2. Polarisator (P2) $\parallel$ y.

Man sieht, daß sich bei diesen relativ kleinen Störeffekten der Fehlwinkel $\delta_3$ der $\lambda/4$-Verzögerungsplatte (9) je nach Polarisationsstellung entweder zu dem oben für $\delta_3 = 0°$ berechneten 90°-Fehler von 2,7° addiert oder subtrahiert. Der 90°-Fehler kann damit durch eine gezielte Wahl von $\delta_3$ auf 0 kompensiert werden.

Eine Drehung des 1. Polarisators (P1) von x nach y bzw. von y nach x wirkt sich auf die 90°-Phasenverschiebung und den Modulationskontrast nicht aus.

Störeffekte, die sich aus einer ungenauen Azimut-Orientierung der Komponenten ergeben, werden hier nicht betrachtet. In der Praxis kann die Winkeleinstellung so genau vorgenommen werden, daß diese Störeffekte keine Rolle spielen.

3. Einfluß des 90°-Prismas (10):

Bei der Totalreflexion ergibt sich im 90°-Prisma (10) zwischen s- und p-Polarisation eine Phasenverschiebung von 36,9° für einen Brechungsindex des Prismas von 1,5.

Falls sich das 90°-Prisma (10) gemäß Fig. 1b im Empfangskanal ohne die λ/4-Verzögerungsplatte (9) befindet, ist diese Phasenverschiebung für die in Fig. 2b angegebenen Winkelorientierungen ohne Einfluß auf die Sensorsignale. Befindet sich das 90°-Prisma (10) gemäß den Fig. 1a und 2a im Lichtpfad mit der λ/4-verzögerungsplatte (9), so müssen sich die λ/4-Verzögerungsplatte (9) und der 2. Polarisator (P2) vor dem 90°-Prisma (10), d. h. zwischen 90°-Prisma (10) und Strahlteiler (1), befinden. Eine Anordnung zwischen dem 90°-Prisma (10) und dem Kollimator (K2) hätte zur Folge, daß sich der Modulationskontrast in diesem Kanal um einen Faktor von ca. 0,8 vermindern würde.

Fig. 5 zeigt die relative optische Leistungsbilanz für den idealen, verlustfreien Fall und ein Teilerverhältnis von 1 : 1 sowohl am Faserkoppler (FK) als auch am Strahlteiler (1). Die an der Lichtquelle (L) in das Glasfaserkabel (F1) eingekoppelte Lichtleistung wird als 100 % angenommen. Nach dem Faserkoppler (FK) bleiben davon noch 50 % übrig. Da das Licht unpolarisiert am 1. Polarisator (P1) ankommt, wird die Lichtleistung durch den 1. Polarisator (P1) ein weiteres Mal halbiert auf 25 % der ursprünglichen Lichtleistung. Nach dem 2maligen Durchlaufen des Strahlteilers (1) sind die Lichtintensitäten auf 6,25 % reduziert. Dies ist die maximale Lichtleistung, entsprechend den Maxima der durch $I_1(t)$ und $I_2(t)$ gegebenen elektrooptischen Modulation, die durch die Analysatoren (P1, P2) in die Empfangskanäle gelangt, In einem Kanal wird diese Lichtleistung durch den Faserkoppler (FK) ein weiteres Mal halbiert, so daß an den Lichtdetektoren (D1, D2) im Maximum der Modulation schließlich noch 3,125 % bzw. 6,25 % der ursprünglichen Lichtleistung eintreffen.

Verwendet man einen Strahlteiler (1) mit einem Verhältnis von Transmission zu Reflexion von 2 : 1 sowohl fürs- als auch für p-Polarisation, so erreicht man, daß die an den beiden Lichtdetektoren (D1, D2) eintreffenden maximalen Lichtleistungen gleich sind. Sie betragen dann jeweils 5,55 % der ursprünglichen Leistung, vergleiche die in Klammern angegebenen Werte.

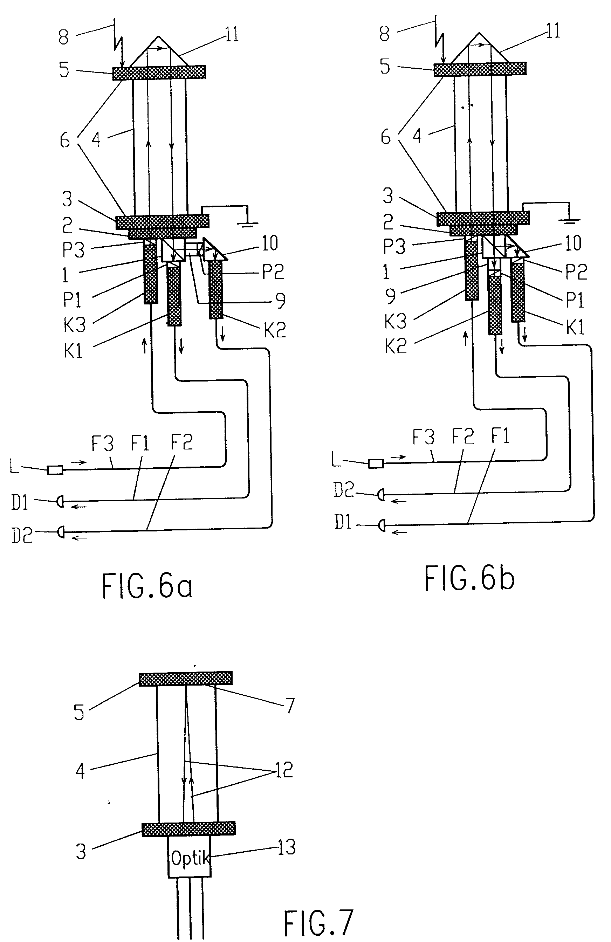

Die Fig. 6a und 6b zeigen 2 weitere Sensorvarianten, bei denen Sende- und Empfangspfade getrennt sind. Jeder der Sensoren benötigt auch hier nur eine Lichtquelle (L). Die beiden 90°-Phasenverschiebungen werden wiederum aus einem gemeinsamen optischen Lichtpfad im elektrooptischen Kristall (4) abgeleitet, so daß die Doppelbrechung des elektrooptischen Kristalls (4) die 90°-Phasenverschiebung nicht beeinflußt. Die Optik zur Erzeugung der 90°-Phasenverschiebung ist die gleiche wie bei den Fig. 1 und 2. Die 2. Glasplatte (3) hat hier wie die 3. Glasplatte (5) eine für optische Signale transparente Schichtelektrode (6). Die Umlenkung des Eingangslichtstrahls erfolgt nicht durch einen Spiegel (7), sondern durch ein 90°-Prisma (11) auf der 3. Glasplatte (5).

Vorteile dieser beiden Sensorvarianten sind:

- Bei den Sensorvarianten gemäß den Fig. 1a und 1b kann vor allem am 1. Lichtdetektor (D1) ein Signaluntergrund infolge von unerwünschten Reflexionen aus dem optischen System auftreten. Die Ursache für solche Reflexionen sind Brechungsindexsprünge an den Grenzflächen, besonders in Fasersteckern. Bei den Sensorkonfigurationen gemäß den Fig. 6a und 6b gelangen solche Reflexe nicht oder nur in sehr abgeschwächter Form an die Detektoren und sind deshalb nicht besonders störend. Die Qualität der Faserstecker kann geringer sein.
- Der Faserkoppler (FK) entfällt.
- Die Lichtleistung an den Lichtdetektoren (D1, D2) ist höher.

Den Vorteilen stehen folgende Nachteile gegenüber:

- Man benötigt eine zusätzliche Glasfaserverbindung zwischen der Sender-/Empfangsseite und dem Sensorkopf.
- Man benötigt einen 3. Kollimator (K3) und einen 3. Polarisator (P3).
- Die Querdimensionen der Optik sind größer. Der notwendige Mindestquerschnitt des elektrooptischen Kristalls (4) wird damit ebenfalls größer.

Bezüglich der Amplituden- und Phaseneffekte gilt das gleiche wie bei den Sensorkonfigurationen gemäß den Fig. 1a und 1b. Zusätzlich sind die relativen Phasenverschiebungen bei der 2maligen Reflexion im 90°-Prisma (11) an der oberen Fläche der 3. Glasplatte (5) um jeweils einen Winkel $\varphi_2$ zwischen s- und p-Polarisation zu betrachten, wobei für einen Brechungsindex des 90°-Prismas (11) von 1,5 der Wert von $\varphi_2 = 36,9°$ beträgt. Damit diese Phasenverschiebungen keinen Einfluß auf die relative Phase der 90°-Phasenverschiebung und den Modulationskontrast haben, sollten die Kanten der Prismengrundfläche parallel zu den elektrooptisch ausgezeichneten Achsen (H1, H2) des elektrooptischen Kristalls (4) ausgerichtet werden. Beide Signale der 90°-Phasenverschiebungen werden dann gemeinsam um die gleichen Phasenwinkel $2 \cdot \varphi_2$ verschoben, wobei jedoch ihre relative Phase unverändert bleibt. Die Signale für die Lichtintensität $I_1$ und $I_2$ lauten dann, in Abänderung der Gleichungen (3) und (4):

$$I_1(t) = I_0 \cdot [A_1 + B_1 \cdot \cos (\Gamma - \epsilon_1) - 2 \cdot \varphi_2]/2 \text{ und} \quad (13)$$
$$I_2(t) = I_0 \cdot [A_2 + B_2 \cdot \cos (\Gamma + \pi/2 - \epsilon_2) - 2 \cdot \varphi_2]/2, \quad (14)$$

wobei Gleichung (13) für den Kanal ohne und Gleichung (14) für den Kanal mit $\lambda/4$-Verzögerungsplatte (9) gilt.

Aus diesen beiden Gleichungen (13, 14) kann die zum einwirkenden Feld bzw. zur Hochspannung (8) proportionale optische Phasenverschiebung $\Gamma$ ermittelt werden, wie es näher in der o. g. US-A-4,904,931 ausgeführt ist. Die gesuchte Spannungsamplitude bzw. das Meßergebnissignal (S) wird dann in Abhängigkeit von der optischen Phasenverschiebung $\Gamma$ durch Kalibrierung bestimmt.

Das Sensorverhalten wird durch die Nullpunktverschiebung nicht beeinträchtigt. Falls es gewünscht wird, kann sie durch je eine zusätzliche Verzögerungsplatte mit einer Verzögerung von $2 \cdot \varphi_2$ in den beiden Kanälen wieder kompensiert werden.

Würde man das 90°-Prisma (11) mit den Kanten unter 45° zu den elektrooptisch ausgezeichneten Achsen (H1, H2) des elektrooptischen Kristalls (4) ausrichten, so hätten die relativen Phasenverzögerungen des 90°-Prismas (11) zusätzliche störende Effekte zur Folge.

Zur Vermeidung des zusätzlichen 90°-Prismas (11) könnte man den Eingangslichtstrahl leicht schräg zur 3. elektrooptisch ausgezeichneten Achse (H3) des elektrooptischen Kristalls (4) laufen und dann wieder an einer Spiegelfläche (7) der 3. Glasplatte (5) reflektieren lassen, entsprechend den in Fig. 7 eingetragenen Lichtpfaden (12). Mit (13) ist eine Optik aus Strahlteiler (1), $\lambda/4$-Verzögerungsplatte (9), Polarisatoren (P1, P2, P3), Kollimatoren (K1, K2, K3) und 90°-Prisma (10) bezeichnet.

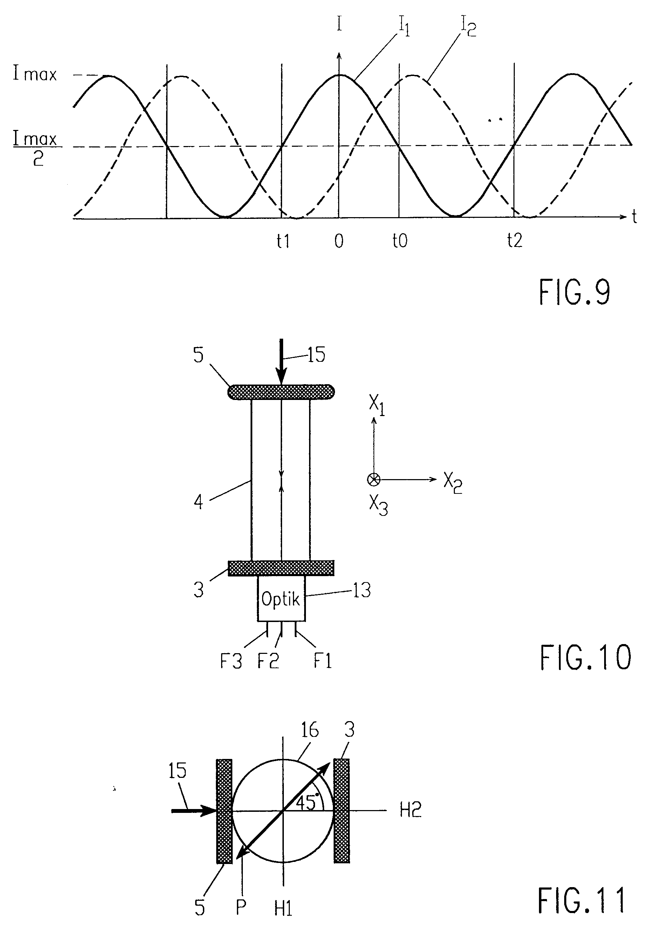

Die optische Leistungsbilanz ist für beide Sensorkonfigurationen gleich und in Fig. 8 für den idealen, verlustfreien Fall dargestellt. In den Maxima der optoelektrischen Modulation kommen jeweils 25 %-der ursprünglichen optischen Leistung an den beiden Lichtdetektoren (D1, D2) an.

Die Lichtquelle (L) sollte vorzugsweise eine kurze Kohärenzlänge haben, so daß z. B. bei Vielfachreflexionen innerhalb der Sensoroptik keine Interferenzeffekte auftreten. Diese könnten sich durch erhöhtes Rauschen störend auf die gemessenen Lichtintensitäten $I_1$ und $I_2$ auswirken. Vorzugsweise kommt eine lichtemmittierende Halbleiterdiode (LED) oder eine multimode Laserdiode zur Anwendung.

Die Glasfaserverbindungen sind Multimode-Faserkabel (F1, F2). Bei Verwendung einer Laserdiode als Lichtquelle (L) ist das Glasfaserkabel (F1) für den Sendepfad mindestens so lang (üblicherweise einige 10 m) zu wählen, daß das am Sensorkopf ankommende Licht ausreichend depolarisiert und genügend inkohärent ist, um Signalschwankungen und Rauschen infolge von Polarisationsfluktuationen und Interferenzeffekten zu unterbinden. Bei getrennten Sende- und Empfangspfaden gemäß den Fig. 6a und 6b ist für den Sendepfad auch eine polarisationserhaltende Monomodefaser (F3) geeignet, wenn eine multimode Laserdiode als Lichtquelle (L) gewählt wird. Mit einer lichtemmittierenden Halbleiterdiode wäre die in die Monomodefaser eingekoppelte optische Leistung zu niedrig. Am Sensorkopf müssen dann die Faserachsen so ausgerichtet werden, daß die Polarisationsrichtung parallel zur Durchlaßrichtung des Eingangspolarisators (P3) liegt.

Bei vereinigten Sende- und Empfangspfaden gemäß den Fig. 1a und 1b ist eine Monomodefaser eher ungeeignet, da für die Wiedereinkopplung des Lichtes in die Faser die Anforderungen an die mechanische Stabilität des Sensoraufbaus wegen des kleinen Faserkerndurchmessers drastisch erhöht wären.

Kristallklassen und -orientierungen, welche sich für eine Linienintegration des elektrischen Feldes eignen und die ohne anliegende elektrische Spannung nicht doppelbrechend sind, sind in der folgenden Tabelle 1 angegeben.

Tabelle 1:

| Klasse | Kristallachse parallel zur Lichtausbreitung (H3) | Richtungen der elektrooptischen Hauptachsen | Materialien |
|---|---|---|---|
| $\overline{4}3m(T_d)$ | $\overline{4}$zählige Achse [001] | [110] und [1$\overline{1}$0] | $Bi_4(SiO_4)_3$ (BSO) |
| | | | $Bi_4(GeO_4)_3$ (BGO) |
| | | | ZnS, ZnSe, CuCl |
| $\overline{4}2m(D_{2d})$ | $\overline{4}$zählige Achse [001] | [110] und [1$\overline{1}$0] | Kaliumdihydrogenphosphat |
| | | | $KH_2PO_4$ (KDP) |
| 23(T) | 2zählige Achse [001] | [110] und [1$\overline{1}$0] | Natriumchlorat $NaClO_3$ |

Die Kristallklassen sind hier mit ihrer internationalen als auch in Klammern mit ihrer Schoenflies-Notation bezeichnet.

Die beiden in Tabelle 2 angegebenen Kristallklassen sind bereits ohne elektrisches Feld doppelbrechend. Die Hauptachsen der intrinsischen Doppelbrechung fallen mit den elektrooptischen Hauptachsen zusammen, so daß sich die intrinsische Doppelbrechung einfach als konstante, bleibende Regelabweichung zu der feldinduzierten Doppelbrechung hinzuaddiert.

Tabelle 2:

| Klasse | Kristallachse parallel zur Lichtausbreitung (H3) | Richtungen der elektrooptischen Hauptachsen || und ⊥ | Materialien |
|---|---|---|---|
| $\bar{6}m2(D_{3h})$ | 2zählige Achse | 3zählige Achse | $LiNaCO_3$ |
| 2mm($C_{2v}$) | 2zählige Achse [001] | [100] und [010] | $MgBaF_4$ |

Daneben gibt es andere Kristallklassen, die grundsätzlich auch für eine Integration geeignet wären, bei denen aber die Achsen der intrinsischen und der feldinduzierten Doppelbrechung verschiedene Richtungen haben. Auf diese Kristallklassen wird deshalb nicht weiter eingegangen.

Wichtig ist, daß Licht mit einer Polarisation, die von 0° und 90° verschieden ist, vorzugsweise im Bereich von 40° - 50°, insbesondere unter 45° zu einer elektrooptisch ausgezeichneten Achse (H1) in den elektrooptischen Kristall (4) eintritt. Nach 2maligem Durchlaufen des elektrooptischen Kristalls (4) (hin und zurück) wird das Licht an dem Strahlteiler (1) in 2 Teilstrahlen (T1, T2) zerlegt. Im 1. Teilstrahl (T1) befindet sich der 1. Polarisator (P1), der als Analysator für diesen Kanal wirkt. Der 2. Teilstrahl (T2) läuft über die $\lambda$/4-Verzögerungsplatte (9), welche die 90°-Phasenverschiebung zwischen den beiden Kanälen herstellt, und dann ebenfalls über einen Analysator (P2). Der am Strahlteiler (1) reflektierte Lichtstrahl wird zusätzlich über das 90°-Prisma (10) gelenkt, so daß sich für die beiden Kanäle parallele Strahlrichtungen ergeben. Dies ermöglicht eine kompakte Bauweise. Die Eigenschaften, Orientierung und Anordnung der optischen Komponenten sind so gewählt, daß die unterschiedlichen Phasenverschiebungen für s- und p-Polarisation bei der Transmission und Reflexion an Grenzflächen (Strahlteiler (1), 90°-Prisma (10)) den Phasenunterschied zwischen beiden Kanälen und den Modulationskontrast nicht wesentlich beeinflussen.

Temperaturkompensation:

Die detektierten elektrooptischen Signale bzw. Lichtintensitäten $I_1$ und $I_2$ sind gewöhnlich temperaturabhängig. Bei $Bi_4(GeO_4)_3$ (BGO) z. B. beträgt der Temperaturkoeffizient des maßgeblichen elektrooptischen Koeffizienten ca. $2,4 \cdot 10^{-4}$ $K^{-1}$, d. h., bei einer Temperaturerhöhung um 100 K nimmt das Signal bei konstanter anliegender Spannung um 2,4 % zu. Für eine genaue Spannungsmessung ist deshalb eine zusätzliche Temperaturmessung erforderlich. Um einen separaten Temperatursensor zu vermeiden, verwendet man eine $\lambda$/4-Verzögerungsplatte (9), deren Verzögerung eine geeignet große Temperaturabhängigkeit besitzt. Aus einer Messung des Phasenunterschiedes ($\Delta\phi$) der beiden elektrooptischen Signale ($I_1$, $I_2$) läßt sich dann die Temperatur der $\lambda$/4-Verzögerungsplatte (9) und ihrer unmittelbaren Umgebung ermitteln. Das Spannungs- bzw. Meßergebnissignal (S) kann dann entsprechend korrigiert werden.

Für eine $\lambda$/4-Verzögerungsplatte (9) 0. Ordnung aus Quarz ändert sich die Verzögerung bei einer Wellenlänge von 633 mm um ca. 0,5°, wenn sich die Temperatur um 50 K verändert. Eine größere Temperaturabhängigkeit kann man durch die Verwendung einer $\lambda$/4-Verzögerungsplatte (9) höherer Ordnung erreichen, da die temperaturbedingte Phasenänderung proportional mit der Ordnungszahl anwächst. Für eine $\lambda$/4-Verzögerungsplatte (9) mit z. B. 2,25 Ordnungen, d. h. mit einer relativen Verzögerung von 2,25 Wellenlängen, ändert sich die Verzögerung um ca. 4,5°, wenn sich die Temperatur um 50 K ändert.

Die Bestimmung des Phasenunterschiedes ($\Delta\phi$) zwischen den beiden elektrooptischen Signalen ($I_1$, $I_2$) wird anhand von Fig. 9 erläutert, in der diese elektrooptischen Signale ($I_1$, $I_2$) in Abhängigkeit von der Zeit (t) dargestellt sind. Der Phasenunterschied ($\Delta\phi$) zwischen beiden elektrooptischen Signalen ($I_1$, $I_2$) entspricht der von der $\lambda$/4-Verzögerungsplatte (9) eingeführten Verzögerung. Diese ist von der Temperatur abhängig. Der Phasenunterschied ($\Delta\phi$) kann aus einer Messung der Zeitpunkte t0, t1 und t2 der Durchgänge von $I_2$ und $I_1$ durch $I_{max}$/2 direkt bestimmt werden gemäß:

$$\Delta\phi = 180° \cdot (t0 - t1)/(t2 - t1). \quad (15)$$

Die Abweichung des Phasenunterschiedes ($\Delta\phi$) von 90° ist folglich: $\Delta\phi' = \Delta\phi - 90°$.

Die $\lambda$/4-Verzögerungsplatte (9) sei so ausgelegt, daß $\Delta\phi$ bei Zimmertemperatur (293 K) 90° und $\Delta\phi'$ dem-

nach = 0 ist. $\Delta\phi'$ ist dann wie folgt von der absoluten Temperatur T abhängig:

$$\Delta\phi'(T) = \gamma \cdot (T - 293), \quad (16)$$

wobei $\gamma$ der Temperaturkoeffizient der $\lambda/4$-Verzögerungsplatte (9) ist. Für eine $\lambda/4$-Verzögerungsplatte (9) mit 2,25 Ordnungen ist

$$\gamma = 0,09° \, K^{-1}. \quad (17)$$

Die Temperatur T des Sensorkopfes kann dann in Grad Kelvin bestimmt werden gemäß:

$$T = \Delta\phi'(T)/\gamma + 293. \quad (18)$$

Mit der nun bekannten Temperatur T kann das von dem Mikroprozessor (14) aus den elektrooptischen Signalen ($I_1$, $I_2$) gewonnene Meßergebnissignal (S) bezüglich der Temperatur T korrigiert werden gemäß:

$$S_k = S \cdot \delta(T), \quad (19)$$

wobei $\delta(T)$ gegeben ist als

$$\delta(T) = 1 + \epsilon(T - 293). \quad (20)$$

$\epsilon$ ist der Temperaturkoeffizient der elektrooptischen Phasenverschiebung. Für $Bi_4(GeO_4)_3$ (BGO) beträgt $\epsilon$ etwa $2,4 \cdot 10^4 \, K^{-1}$.

Die Kalibrierung des Sensors ist so vorzunehmen, daß sich für T = 293 K mit $\delta(293 \, K) = 1$ das gewünschte Signal (S) ergibt. Für den Fall, daß der Sensor zur Kraftmessung eingesetzt wird (siehe weiter unten), ist in Gleichung (20) der Temperaturkoeffizient der mechanisch induzierten Doppelbrechung einzusetzen.

Bei Kristallen der Klassen 6m2 und 2mm, die eine intrinsische Doppelbrechung haben, kann man die Temperaturabhängigkeit dieser Doppelbrechung für eine Temperaturmessung heranziehen. Eine Änderung der Doppelbrechung führt zu einer zusätzlichen, langsamen Phasenverschiebung der beiden elektrooptischen Signale ($I_1$, $I_2$). Diese Phasenverschiebung ist für beide elektrooptischen Signale ($I_1$, $I_2$) gleich groß. Hinzu kommt die temperaturabhängige Änderung ihrer relativen Phase auf Grund der Temperaturabhängigkeit der $\lambda/4$-Verzögerungsplatte (9), die aber im Vergleich zu der absoluten Verschiebung vernachlässigbar klein ist.

Die langsame, von der Temperatur abhängige Phasenverschiebung kann in Inkrementen von 90° aus der Zahl der insgesamt auftretenden Nulldurchgänge der beiden elektrooptischen Signale ($I_1$, $I_2$) ermittelt werden. Zählt man die Nulldurchgänge bei positiver Phasenverschiebung mit positivem Vorzeichen und diejenigen bei negativer Phasenverschiebung mit negativem Vorzeichen, so ist die Gesamtzahl der akkumulierten Nulldurchgänge, die von der angelegten Wechselspannung (8) verursacht werden, nach jeder vollen Periode der Wechselspannung (8) = 0. Alle zusätzlich auftretenden Nulldurchgänge sind auf Temperaturänderungen oder Gleichspannungsanteile zurückzuführen. Die Zahl der Nulldurchgänge infolge von Gleichspannungen ist aber im Vergleich zu temperaturinduzierten Nulldurchgängen vernachlässigbar klein.

Die Phasenverschiebung auf Grund der intrinsischen Doppelbrechung ist bei 2maligem Lichtdurchlauf durch den elektrooptischen Kristall (4) gegeben als:

$$\Delta\Gamma = 4 \cdot \pi \cdot L \cdot \Delta n/\lambda \quad (21)$$

mit L = Kristallänge, $\lambda$ = Wellenlänge des Lichtes, $\Delta n$ = Differenz der Brechungszahlen bei der Doppelbrechung.

Bei einer Temperaturänderung $\Delta T$ ändert sich die Phase um

$$\delta\Gamma(\Delta T) = \Delta\Gamma \cdot \gamma_{\Delta n} \cdot \Delta T. \quad (22)$$

$\gamma_{\Delta n} = \delta\Delta n/(\Delta n \cdot \delta T)$ ist der Temperaturkoeffizient der Doppelbrechung.

$\delta\Gamma(\Delta T)$ ergibt sich aus der Anzahl $N(\Delta T)$ der zusätzlichen Nulldurchgänge in Inkrementen von $\pi/2$ bzw. 90° gemäß:

$$\delta\Gamma(T) = N(\Delta T) \cdot \pi/2. \quad (23)$$

Die Temperaturabhängigkeit ist also:

$$\Delta T = [N(\Delta T) \cdot \pi]/(2 \cdot \Delta\Gamma \cdot \gamma_{\Delta n}). \quad (24)$$

Bei dieser Methode können nur Temperaturänderungen gemessen werden. Die Anfangstemperatur $T_a$ muß bei jeder Inbetriebnahme des Sensors neu eingegeben werden. Es ist dann:

$$T = T_a + \Delta T. \quad (25)$$

Beispiel:

Für eine Doppelbrechung mit $\Delta n = 0,01$, einen Temperaturkoeffizienten der Doppelbrechung $\gamma_{\Delta n} = 10^{-4} \, K^{-1}$, eine Kristallänge L = 10 cm, eine Wellenlänge $\lambda$ = 780 nm und einen 2maligen Lichtdurchlauf durch den elektrooptischen Kristall (4) ergibt sich:

- eine totale Phasenverschiebung

$$\Delta\Gamma = 1,6 \cdot 10^4 \, rad, \quad (26)$$

- eine Phasenverschiebung bei einer Temperaturänderung um $\Delta T$:

$$\delta\Gamma = 1,61 \cdot \Delta T. \quad (27)$$

Für $\Delta T$ = 1 K ergibt sich $\delta\Gamma$ = 1,61 rad oder 92°.

Der Sensor kann grundsätzlich auch für eine dynamische optische Druck- bzw. Kraftmessung eingesetzt werden. Eine mögliche Konfiguration ist in Fig. 10 dargestellt. Eine Kraft (15) wirkt hier parallel zu einer Lichtausbreitungsrichtung $(X_1)$. Bei geeigneter Wahl der Kristallklasse und Kristallorientierung wird der elektrooptische Kristall (4) für Licht, das sich entlang der Lichtausbreitungsrichtung $(X_1)$ ausbreitet, doppelbrechend. Bei einem kubischen Kristall (4) der Klassen 23 (T) oder m3 $(T_h)$ soll eine Lichtausbreitungsrichtung (X3) mit einer der 3 Würfelachsen zusammenfallen. Die 3 Hauptbrechungsindizes für die Polarisationsrichtungen parallel zu den Würfelachsen ändern sich dann gemäß:

$$\Delta n_1 = - n_0^3 \cdot \pi_{11} \cdot \sigma/2,$$
$$\Delta n_2 = - n_0^3 \cdot \pi_{13} \cdot \sigma/2,$$
$$\Delta n_3 = - n_0^3 \cdot \pi_{12} \cdot \sigma/2,$$

wobei $n_0$ den Brechungsindex ohne angelegte Kraft (15), $\sigma$ die angelegte Kraft (15) pro Fläche und $\pi_{ij}$ photoelastische Koeffizienten bedeuten. Für einen elektrooptischen Kristall (4), der einer der 3 anderen kubischen Klassen 43m, 432, m3m $(T_d, O, O_n)$ angehört, ist $\pi_{12} = \pi_{13}$ und damit $\Delta n_2 = \Delta n_3$. Diese Klassen sind damit für eine Druckmessung in der Konfiguration gemäß Fig. 10 nicht geeignet.

Für die Klassen 23 und m3 ist die Doppelbrechung gegeben durch:

$$\Delta n = \Delta n_2 - \Delta n_3 = - n_0^3 \cdot (\pi_{13} - \pi_{12}) \cdot \sigma/2.$$

Die Polarisationsrichtung des einfallenden Lichtes bildet mit den $X_2$- und $X_3$-Achsen vorzugsweise einen 45°-Winkel. Der resultierende Phasenunterschied, den die beiden orthogonalen Polarisationsanteile parallel zu $X_2$ und $X_3$ beim 2maligen Durchlaufen des elektrooptischen Kristalls (4) der Länge (L) akkumulieren, ist gegeben durch Gleichung (26).

Beispiel:

Die Differenz $\pi_{13} - \pi_{12}$ hat gewöhnlich die Größenordnung von $10^{-12}$ m²/N. Mit $n_0 = 2$, $L = 0,1$ m, $\sigma = 10^6$ N/m² und $\lambda = 780$ nm erhält man $\Delta\Gamma = 6,44$ rad oder 369°.

Zur Kraftmessung könnten auch nichtkubische Kristallklassen herangezogen werden.

Statt longitudinal auf einen elektrooptischen Kristall (4) könnte die Kraft (15) auch transversal auf einen im Querschnitt dargestellten Glasstab (16) ausgeübt werden, gemäß Fig. 11. Die Polarisation (P) des einfallenden Lichtes müßte hier vorzugsweise 45° zur Richtung der Kraft (15) liegen. (H1) und (H2) bezeichnen Hauptachsen der induzierten Doppelbrechung.

## BEZEICHNUNGSLISTE

| | |
|---|---|
| 1 | Strahlteiler |
| 2, 3, 5 | Glasplatten |
| 4 | elektrooptischer Kristall |
| 6 | Schichtelektroden |
| 7 | Spiegel, Verspiegelung |
| 8 | Hochspannung, elektrische Spannung |
| 9 | Phasenverzögerungsplatte, $\lambda/4$-Verzögerungsplatte |
| 10, 11 | 90°-Prismen |
| 12 | Lichtpfade in 4 |
| 13 | Optik |
| 14 | Auswertelektronik, Rechner, Mikroprozessor |
| 15 | Kraft |
| 16 | Glasstab |
| $A_2, B_2$ | Koeffizienten zur Beschreibung des Modulationskontrastes |
| $a_s$ | Amplitude für s-Polarisation |
| $a_p$ | Amplitude für p-Polarisation |
| D1, D2 | Lichtdetektoren, optoelektrische Detektoren |
| FK | Faserkoppler |
| F1, F2 | Glasfaserkabel |
| F3 | Monomodefaser |
| H1, H2, H3 | kristallographisch ausgezeichnete Achsen von 4 |
| $I_1, I_2$ | gemessene Lichtintensitäten |
| $I_{max}$ | Maximalamplitude von $I_1, I_2$ |
| K1, K2, K3 | Kollimatoren |
| L | Lichtquelle |
| P | Polarisationsrichtung |

| | |
|---|---|
| P1, P2, P3 | Polarisatoren |
| S | Meßergebnissignal |
| t | Zeit |
| t0, t1, t2 | Zeitpunkte |
| T | Temperatur |
| T1, T2 | Teilstrahlen |
| u, v, w | zueinander orthogonale Kanten von 1 bzw. 10 |
| x, y | Polarisationsrichtungen |
| $X_1, X_2, X_3$ | Lichtausbreitungsrichtungen |
| $\delta_1$ | relative Phasenverzögerung |
| $\Delta\phi$ | Phasenunterschied |
| $\in_2$ | Fehler bezüglich der Phasenverschiebung um 90° |

## Patentansprüche

1. Verfahren zur optischen Ermittlung einer physikalischen Größe, welche bei einem Durchgang eines Lichtstrahles durch ein optisches Medium (4, 16) eine Phasenverschiebung des Lichtes bewirkt,

   a) wobei ein linearpolarisierter Eingangslichtstrahl mit einem vorgebbaren 1. Polarisationswinkel bezüglich einer 1. elektrooptisch ausgezeichneten Achse (H1) eines elektrooptischen Kristalls (4), der 3 ausgezeichnete Achsen (H1, H2, H3) aufweist, durch diesen elektrooptischen Kristall (4) gelenkt wird,

   b) wobei 2 aus dem elektrooptischen Kristall (4) austretende 1. und 2. Teilstrahlen (T1, T2) detektiert werden und

   c) wobei sowohl die 1. elektrooptisch ausgezeichnete Achse (H1) als auch eine dazu orthogonale 2. elektrooptisch ausgezeichnete Achse (H2) in einer Ebene liegen, die orthogonal zu einer 3. ausgezeichneten Achse (H3) orientiert ist, in welcher sich, ohne elektrisches Feld oder Kraftfeld, Licht polarisationsunabhängig ausbreitet und wobei sich Licht, bei Einwirkung eines elektrischen Feldes oder eines Kraftfeldes auf den elektrooptischen Kristall (4), in Richtung der 1. elektrooptisch ausgezeichneten Achse (H1) schneller ausbreitet als in Richtung der 2. elektrooptisch ausgezeichneten Achse (H2),

   dadurch gekennzeichnet,

   d) daß dieser Eingangslichtstrahl nach einer Umlenkung durch diesen elektrooptischen Kristall (4) zurückgelenkt und

   e) danach durch einen Strahlteiler (1) und einen 1. Polarisator (P1) einerseits zu einem 1. optoelektrischen Detektor (D1) gelenkt wird, welcher ausgangsseitig ein 1. Phasensignal ($I_1$) liefert,

   f) sowie andererseits über einen Phasenschieber (9) mit einer vorgebbaren 1. Phasenverschiebung und einen 2. Polarisator (P2) zu einem 2. optoelektrischen Detektor (D2) gelenkt wird, welcher ausgangsseitig ein bezüglich des 1. Phasensignals ($I_1$) phasenverschobenes 2. Phasensignal ($I_2$) liefert.

2. Verfahren nach Anspruch 1. dadurch gekennzeichnet,

   a) daß der 1. Polarisationswinkel im Bereich von 30° - 60°,

   b) insbesondere im Bereich von 40° - 50° liegt.

3. Verfahren nach Anspruch 1 oder 2, dadurch gekennzeichnet, daß der in den elektrooptischen Kristall (4) hineingeschickte Eingangslichtstrahl und der umgelenkte, durch den elektrooptischen Kristall (4) zurückgelenkte Lichtstrahl auf unterschiedlichen Lichtpfaden (12) durch den elektrooptischen Kristall (4) gelenkt werden.

4. Verfahren nach einem der vorhergehenden Ansprüche, dadurch gekennzeichnet, daß ein aus den 1. und 2. Phasensignalen ($I_1$, $I_2$) abgeleitetes Meßergebnissignal S bezüglich seiner Temperaturabhängigkeit korrigiert wird, gemäß

$$S_k = S \cdot \delta(T)$$

mit $\delta(T) = 1 + \in(T - 293)$, $\in$ = Temperaturkoeffizient der elektrooptischen Phasenverschiebung, $T = \Delta\phi'/\gamma + 293$ = Temperatur des Phasenschiebers (9) in Grad Kelvin, $\gamma$ = dessen Temperaturkoeffizient, $\Delta\phi' = 180° \cdot (t0 - t1)/(t2 - t1) - 90°$ , t1, t2 = aufeinanderfolgende Durchgänge des 1. Phasensignals ($I_1$) durch $I_{max}/2$, t0 = Durchgang des 2. Phasensignals ($I_2$) durch $I_{max}/2$, t1 < t0 < t2, $I_{max}$ = Maximalamplitude von ($I_1$, $I_2$).

5. Verfahren nach einem der Ansprüche 1 bis 3, dadurch gekennzeichnet, daß ein aus den 1. und 2. Phasensignalen ($I_1$, $I_2$) abgeleitetes Meßergebnissignal S bezüglich seiner Temperaturabhängigkeit korrigiert wird, gemäß

$$S_k = S \cdot \delta(T)$$

mit $\delta(T) = 1 + \epsilon(T - 293)$, $\epsilon$ = Temperaturkoeffizient der mechanisch induzierten Doppelbrechung, $T = T_a + \Delta T$, $T_a$ = Anfangstemperatur, $\Delta T = N \cdot \pi/(2 \cdot \Delta\Gamma \cdot \gamma_{\Delta n})$, $\Delta\Gamma = 4 \cdot \pi \cdot L \cdot n/\lambda$, L = Kristallänge, $\lambda$ = Wellenlänge des Lichtes, $\Delta n$ = Differenz der Brechungszahlen bei der Doppelbrechung, N = Anzahl zusätzlicher Nulldurchgänge in Inkrementen von $\pi/2$.

6. Vorrichtung zur Erzeugung von phasenverschobenen Signalen an einem elektrooptischen Sensor zur Durchführung des Verfahrens nach Anspruch 1,
    a) mit einer Lichtquelle (L),
    b) die über einen 1. Polarisator (P1, P3)
    c) mit einer 1. Lichteintrittfläche eines elektrooptischen Kristalls (4) in optischer Verbindung steht,
    d) mit mindestens einer Phasenverzögerungsplatte (9) und
    e) mit mindestens einem 2. Polarisator (P1, P2) zwischen einer 1. Lichtaustrittfläche des elektrooptischen Kristalls (4) und mindestens einem Lichtdetektor (D2) zur Umwandlung optischer in elektrische Signale ($I_2$),
dadurch gekennzeichnet,
    e) daß der elektrooptische Kristall (4) auf einer der 1. Lichteintrittfläche gegenüberliegenden 2. Fläche mit einer Einrichtung (7, 11) zur Umkehrung des Lichtes durch den elektrooptischen Kristall (4) in Verbindung steht und
    f) daß die 1. Lichteintrittfläche gleich der 1. Lichtaustrittfläche ist.

7. Vorrichtung nach Anspruch 6, dadurch gekennzeichnet, daß die 1. Lichtaustrittfläche des elektrooptischen Kristalls (4) über einen Strahlteiler (1)
    a) einerseits mit der Phasenverzögerungsplatte (9) und
    b) andererseits über einen Polarisator (P1) mit mindestens einem weiteren Lichtdetektor (D1) zur Umwandlung optischer in elektrische Signale ($I_1$) in optischer Verbindung steht.

8. Vorrichtung nach Anspruch 7, dadurch gekennzeichnet, daß der Strahlteiler (1) über ein 90°-Prisma (10) mit einem der Lichtdetektoren (D1, D2) in optischer Verbindung steht.

9. Vorrichtung nach einem der Ansprüche 6 bis 8, dadurch gekennzeichnet, daß die Einrichtung (7, 11) zur Umkehrung des Lichtes durch den elektrooptischen Kristall (4)
    a) ein Spiegel (7) oder
    b) ein 90°-Prisma (11) ist.

10. Vorrichtung nach einem der Ansprüche 6 bis 9, dadurch gekennzeichnet,
    a) daß der elektrooptische Kristall (4) mit seiner 1. Lichteintrittfläche sowie mit seiner gegenüberliegenden 2. Fläche mit elektrisch leitenden Schichtelektroden (6) in Verbindung steht,
    b) insbesondere, daß die Schichtelektrode (6) an der 1. Lichteintrittfläche lichtdurchlässig ist.

FIG.1a

FIG.1b

FIG.3

FIG.2a

FIG.2b

$\dfrac{B_2}{A_2}$ ↑

1,0
0,9
0,8
0,7
0,6
0,5
0,4
0,3
0,2
0,1
0,0

$a_S / a_p = 0,5$
$a_S / a_p = 0,9$
$a_S / a_p = 1,0$

0   10   20   30   40   50   60   70   80   90

→ $\delta_1^\circ$

## FIG.4

**FIG.5**

7

12,5%
(16,6%)

12,5%
(16,6%)

6,25%
(5,55%) →

1

25%

P1   6,25%
(11,1%)

50%

3dB

L   100% →   FK

50% →

D1   ← 3,125%
(5,55%)

← 6,25%
(11,1%)

D2   ← 6,25%
(5,55%)

**FIG.8**

11   50%

50%

1   (1:1)

P3   25% →

25%

100%

L   100% →

D1   ← 25%

D2   ← 25%

FIG.6a

FIG.6b

FIG.7

FIG.9

FIG.10

FIG.11